# EUROPEAN PATENT APPLICATION

(11) **EP 2 182 633 A1**
(43) Date of publication of application: **05.05.2010**
(21) Application number: 08105699.6
(22) Date of filing: 30.10.2008
(51) Int. Cl.: H03H 19/00, H03H 11/12

(54) **Circuits for ultrasonic transducers**

(71) Applicant: University College Cork, Cork City (IE)
(72) Inventor: McSweeney, Sean G, Bweeng Mallow, Cork (IE); Wright, William M.D., Midleton, Co. Cork (IE)
(74) Representative: Lucey, Michael

(57) **Abstract**

The invention relates to circuits for ultrasonic transducers. In one embodiment the invention provides a parametric equalizer, suitable for use in an analogue circuit, **characterised in that** the parametric equalizer comprises a switching capacitor filter circuit; an oscillator wherein the oscillator controls the operation of the switching capacitor filter circuit. The oscillator is preferably a Voltage Controlled Oscillator (VCO). In a further embodiment the invention provides a circuit for use to condition the transmission and/or reception signals of an ultrasonic transducer, comprising an equivalent inductor circuit, for example a resonator circuit, having at least one operational amplifier; and a sliding rail element coupled to the operational amplifier.

## Description

### Field of the Invention

The invention relates to a parametric equalizer and an equivalent inductor circuit. In particular the invention relates to a switched capacitor parametric equalizer architecture and/or equivalent inductor circuit for use with ultrasonic transducers.

### Background to the Invention

Capacitive ultrasonic transducers (CUTs) and capacitive micromachined ultrasonic transducers (cMUTs) are well established technologies having many applications, including increasing application in medical and industrial measurement circuits. Whilst their performance in air is generally superior to that of most piezoelectric devices, many CUT and cMUT designs are still highly resonant to increase their sensitivity. Hence, both air-coupled and immersion devices could benefit significantly by bandwidth and resonance modification through the use of selective networks.

Resonator circuits are widely employed in EMRF (Electromagnetic Radio Frequency) transmission and receive systems including among others passive, cascode active and cascade active selective designs. Selective networks allow for maximising the excitation signal of a sensor off resonance, assuming that a physical limit of the sensor is not exceeded (e.g. dielectric strength, membrane stress, collapse force etc.). The frequency response of the sensor when viewed from outside the network is modified. Such conditioning usually comes at the expense of power consumption, phase distortion, non linearity and reduced SNR (signal to noise ratio) or some combination of these effects.

As such the use of front end mounted components in Ultrasonic Transducers is known in the art, filter networks have been tightly integrated into capacitive sensing and transmission devices by a number of groups. Flip chip bonding has been used to integrate CMUT arrays with ASIC designs as well as being integrated on a single monolithic IC.

The bandwidth of an ultrasonic system can most practically be defined as the transmission envelope of a transmitter/receiver pair. In air, a transmitter will typically be made highly resonant by design in order to maximise range. However, a receiver should inherently have a wider bandwidth as the thinner membrane dominates the oscillations to a lesser extent. At close range, the additional transmit power afforded it by a resonant design is unnecessary and any extra bandwidth on the transmission end of such a system can have significant impact on the overall sensor resolution.

One of the main problems in using CUT and cMUTs in air is their relatively narrow bandwidth which, although superior to that of current piezoceramic devices, could be improved. Some of the other problems that exist are the control of transmit and receive operation at chip level of bandwidth, large circuitry footprint and high power consumption.

The inherent problems with the manufacturing variability includes dimensional variation in the case of CUTs resulting in response variability, and in the case of cMUTs there can be minor layer thickness variations or residual stress variation across each wafer or between wafers. The effects of these minor variations in the manufacture of the devices could in principle be tuned out by adjustment of the device response to compensate for the variations.

Another problem in the technical field is that the frequency response of piezoelectric devices is determined by the thickness of the piezoelectric element, for high frequencies these elements are very thin and difficult and expensive to manufacture.

Numerous patents in the field describe circuits to overcome some of the above mentioned problems. For example, US Patent Number US4,975,663 describes an operational amplifier equalisation technique. US Patent Number US4,606,071 describes an LCR resonator equalizer and as such is a design only realisable in a macro circuit. US Patent Number US5,768,313 describes an adaptive digital equaliser. US Patent Number US6,405,093 describes an amplitude equalisation device in the digital domain similar to US5,768,313.

US Patent Number US6,032,166 describes a single filter package and uses a digital filtering stage which necessitates the use of a processor core and thus result in higher power consumption that would make the design impracticable in a CUT or cMUT system.

US Patent Number US7,058,126 describes a digital graphometric equalizer, however the equalizer described requires a large footprint due to the requirement for a processor core and ADC/DAC for implementation as front-end electronics in any CUT/CMUT device.

There is therefore a need to provide an improved architecture, device, circuit and/or methodology to solve the above mentioned problems.

### Summary of the Invention

According to the present invention there is provided, as set out in the appended claims, parametric equalizer, suitable for use in an analogue circuit, characterised in that the parametric equalizer comprises a switching capacitor filter circuit; and an oscillator wherein the oscillator controls the operation of the switching capacitor filter circuit. The oscillator can be in the form of a voltage controlled oscillator (VCO), or a current controlled oscillator, or a frequency controlled oscillator.

One of the main advantages of the invention is to allow parametric equalisation of a signal in the ultrasonic region, for application as front-end electronics for Capacitive Micro-machined Ultrasonic Transducers (CMUTs), Capacitive Ultrasonic Transducers (CUTs), or ultrasonic transducers based on other transduction principles. It will be appreciated that other applications would also be possible based on using the present device as a building block or possibly the application of the technique to other transducer technologies.

Further advantages of the present invention is that the equalizer allows for miniaturisation of analogue parametric equalisers well beyond current designs through the use of adaptable switching capacitor circuits controlled by VCOs (Voltage-Controlled Oscillators). The invention also allows for easy integration onto a single IC with a micromachined ultrasonic transducer. A further benefit is the lower power consumption associated with this device, afforded by the use of analogue methods which could be critical in remote monitoring applications for capacitive based transducers.

In one embodiment the parametric equalizer is coupled to a Capacitive Ultrasonic Transducer (CUT), such that said parametric equalizer conditions the transmission and reception characteristics of said CUT.

In another embodiment the parametric equalizer is coupled to a Capacitive Micro-machined Ultrasonic Transducer (CMUT) such that said parametric equalizer conditions the transmission and reception characteristics of said CMUT.

In another embodiment the parametric equalizer is coupled to an ultrasonic transducer that operates on a piezoelectric, magnetostrictive, electrostrictive, ferroelectric, piezoresistive, electromagnetic or other transducer principle, such that said parametric equalizer conditions the transmission and reception characteristics of said ultrasonic transducer.

Ideally, the equalizer comprises means for manipulating a single pole/zero within the transducer response characteristic to modify a response characteristic as desired. The manipulation means may comprise a first order filter circuit.

In another embodiment the equalizer comprises means for manipulation of multiple poles/zeros within the transducer response characteristic to modify the response characteristic as desired. The manipulation means comprises at least one bi-quadratic filter circuit.

By manipulating the poles/zeroes of a resonator circuit consisting of front-end mounted components, the transmission characteristics can be modified to enhance transducer performance. One of the advantages for CUTs and cMUTs is that variations in transducer performance produced by any lack of repeatability in their manufacture may be reduced or even eliminated. For cMUTs, an additional advantage is that the selective network may be incorporated with the transducer on a suitable CMOS-compatible IC. The transducer comprises means for using multiple poles/zeros to shift the centre frequency of the response. The transducer may comprises means for using multiple poles/zeros to manipulate the transient response of the transducer.

The present invention may be used to compensate for variations in element thickness and other element properties to produce more consistent response levels from transduction devices at a lower power point, or to use cheaper less stringent transducer manufacturing processes.

The use of an equaliser in capacitive ultrasonic devices also provides a means of compensating for device response variation over time due to dielectric charging effects resulting in consistent output voltages.

In a further embodiment of the present invention there is provided a circuit for use to condition the transmission and reception signals of a CUT, CMUT, or other transducer technology comprising an equivalent inductor circuit, for example a resonator circuit, having at least one operational amplifier; and a sliding rail element coupled to said operational amplifier. One of the advantages of this circuit is that it facilitates the introduction of an inductance of an arbitrary value within the circuit to allow the miniaturisation of the other filter elements, as well as allowing wide signal manipulation/conditioning.

Ideally, the sliding rail element conditions the signal to an approximate level. Preferably the operational amplifier fine tracks the conditioned signal. The manipulation means comprises a first order filter circuit. The circuit comprises means for using multiple poles/zeros to manipulate the frequency response of the transducer system. The manipulation means comprises at least one bi-quadratic filter circuit. The circuit comprises means for using multiple poles/zeros to shift the centre frequency of the transducer system response.

There is also provided a computer program comprising program instructions for causing a computer program to to control the above circuits, which may be embodied on a record medium, carrier signal or read-only memory.

### Brief Description of the Drawings

The invention will be more clearly understood from the following description of an embodiment thereof, given by way of example only, with reference to the accompanying drawings, in which:-
Figure 1 illustrates a basic equivalent electrical circuit model for an ultrasonic transducer (in this case a CUT);
Figure 2 illustrates a basic LCR equivalent circuit;
Figure 3 illustrates a BJT amplifier circuit;
Figure 4 illustrates a block diagram of parametric equalizer architecture according to a first aspect of the invention;
Figure 5 illustrates block diagram of the overall architecture of the parametric equalizer as provided in figure 4;
Figure 6 illustrates a resonator incorporating sliding rail equivalent inductor according to another aspect of the invention;
Figure 7 illustrates a circuit diagram of Figure 6;
Figure 8 illustrates a single element block level diagram;

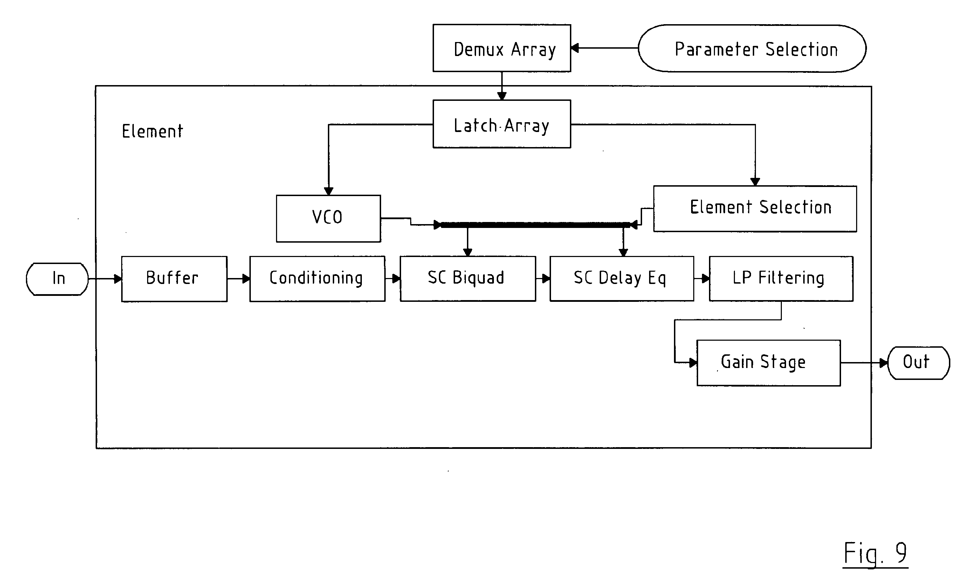

Figure 9 illustrates various configuration elements of selective networks according to the invention;
Figure 10 is a simulation result with a schematic including the equivalent circuit models for the transmission and reception CUTs; and
Figure 11 to 13 illustrates experimental results from a modelled CUT pair using impulse response as the measurement method.

### Detailed Description of the Drawings

Referring now to the drawings the invention provides for the manipulation of the excitation properties of a capacitive (micro-machined) ultrasonic transducer (hereafter referred to as "transducer") or a transducer based on any other transduction principle through the use of selective networks. The invention facilitates transmission envelope modification including bandwidth widening/ reduction, roll off increase/decrease, resonance shifting and ripple suppression among other parameters that would be expected of an analogue equaliser system. The invention provides for the manipulation of a signal using a switched capacitor parametric equalizer for small signal or a sliding rail Antoniou resonator circuit for large signal.

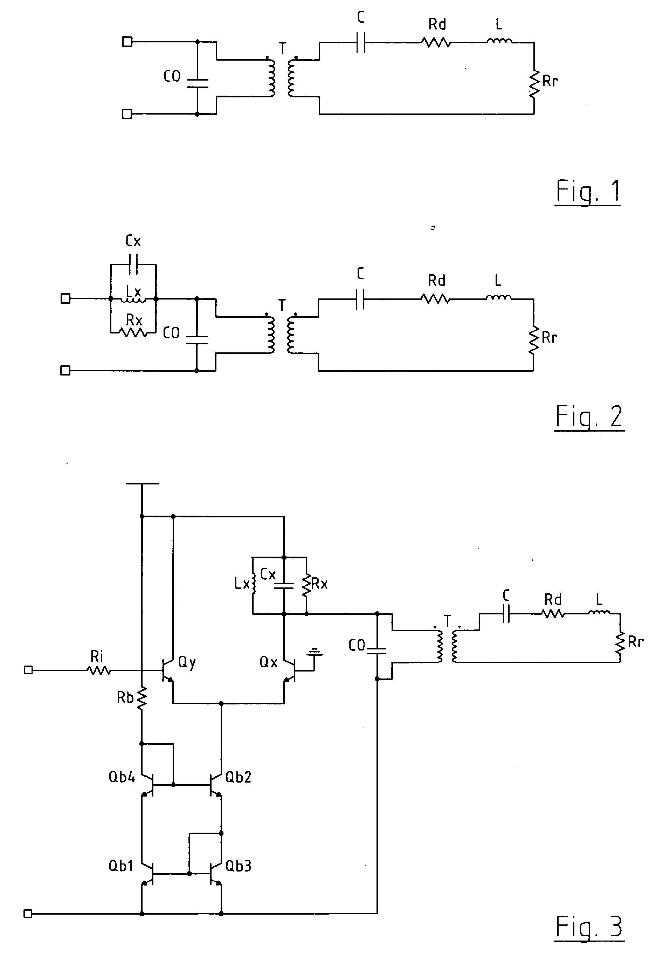

Mason's equivalent circuit for a CUT circuit is shown below in Fig 1 is known in the art. In the electrical equivalent circuit the electroacoustic transformation factor (T), radiation impedance (Rr), dissipation impedance (Rd), mechanical inductance (L) and mechanical capacitance (C) are modeled as lumped element parameters. The transducer capacitance is modeled by C0. The voltage across the electroacoustically transformed equivalent radiation resistance can be related to pressure along the acoustic axis

The basic structure of a prior art LCR resonator circuit is shown below in Fig 2, for simplicity line matching and delay compensation circuitry are omitted. This circuit was used as a test circuit of the concept of manipulation of the transducer response in a predictable manner using passive elements.

Figure 3 illustrates the basic known structure of a BJT (Bipolar Junction Transistor) common collector common base cascade tuned amplifier design including a Wilson current mirror used for biasing which was used to test the concept of developing highly resonant behaviour in broadband capacitive devices.

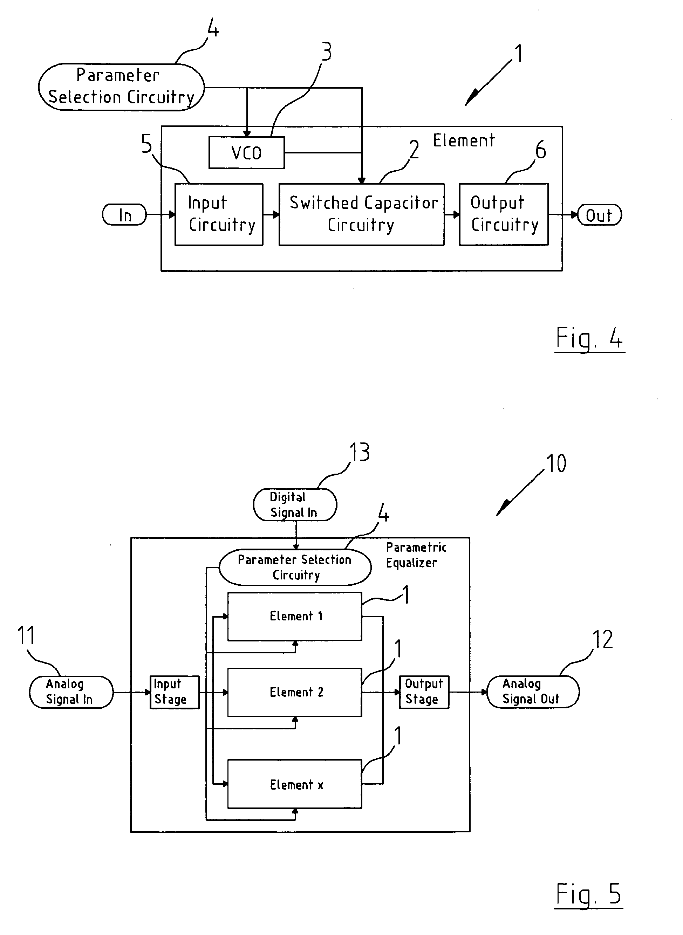

Referring now to Figures 4 and 5 illustrates the first embodiment of the present invention. Figure 4 shows a block diagram of a parametric equalizer element according to the present invention, indicated generally by the reference numeral 1 having a switching capacitor filter circuit 2 and coupled to an oscillator 3, for example a VCO. The oscillator 3 controls the operation of the switching capacitor filter circuit 2. Parameter selection circuitry 4 provides parameter signals to the oscillator 3 and the switched capacitor circuit 2. The switched capacitor filter circuit is connected to input and output circuitry 5, 6.

As can be seen, Figure 5 indicated generally by the reference numeral 10, comprises a number of elements 1 as described above , each element 1 of which is controlled in part by the oscillator 3 (voltage, frequency or current controlled) and standard input and output analog circuitry 11, 12. Each of the elements 1 can be independently controlled digitally 13 to operate as desired by the end user. It will be appreciated that clock, I/O and rail gating circuitry is not shown in these block level diagrams, but is included in the parameter selection circuitry 4 to further increase power saving. The parametric equaliser design as shown at block level in Figures 4 and 5 facilitates low power operation of the transducer circuitry for power critical operations where the consumption of a digital signal processing core equalising the signal may be undesirable. Additionally the ability to modify response properties of the devices, as viewed from the transmit/receive circuitry, easily during operation improves the versatility of a particular transducer.

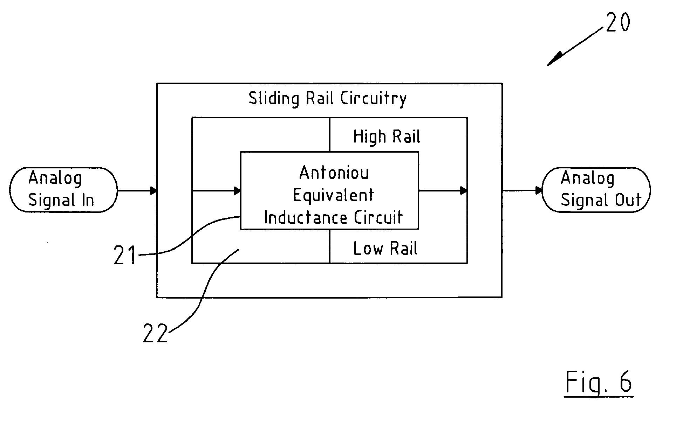

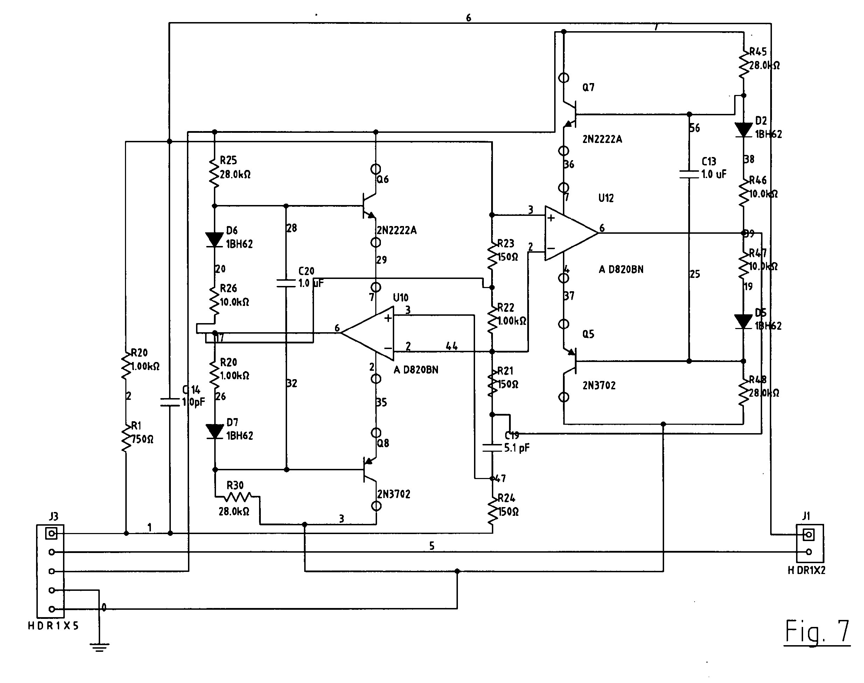

A second embodiment of the present invention embodying a sliding rail Antoniou equivalent inductor circuit can be seen in Figure 6 and 7. Figure 6, indicated generally by the reference numeral 20 illustrates a circuit for use to condition the transmission and/or reception signals of a CUT, CMUT, or other transducer circuit. The circuit has an equivalent inductor circuit 21, for example a resonator circuit, having at least one operational amplifier. A sliding rail element 22, for example an Antoniou equivalent inductor circuit, is coupled to the operational amplifier. The sliding rail element 22 conditions the signal to an approximate level, while the operational amplifier fine tracks the conditioned signal.

A particular implementation of a large signal resonator with the sliding rail Antoniou equivalent inductance circuit is shown in Figure 7 which gives an indication of the circuit level architecture of the design. As can be seen the rails of the op amps of the Antoniou circuit are shifted with appropriately chosen bipolar junction transistors and a number of passive elements used to compensate for noise and signal level. It will be appreciated that the circuitry can be implemented with other similar transistor technologies and differing sliding rail methods.

The transducer circuit of Figure 7 comprises a manipulation means for using a single pole, wherein the manipulation means comprises a first order filter circuit. The circuit comprises means for using multiple poles/zeros to manipulate the frequency response of the transducer circuit, for example using at least one bi-quadratic filter circuit. In another embodiment the circuit comprises means for using multiple poles/zeros to shift the centre frequency of the transducer system response.

The advantage of this form of equivalent inductor is that it allows for the miniaturisation of designs that require the inductance function with a large voltage swing. The sliding rail element conditions the signal to an approximate level. The operational amplifier fine tracks the conditioned signal.

The architecture of the design has been decided upon and most of the analogue processing elements of the design were simulated including the switched capacitor biquadratic template cell, the VCO cell for each biquadratic sections, the delay equaliser template cell and the output section.

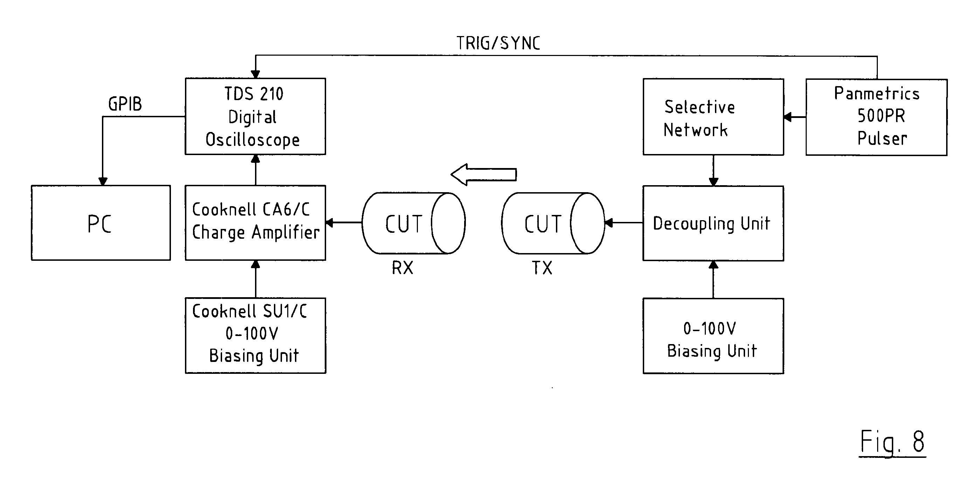

The experimental system constructed to test the various configurations of the selective networks designed is shown in Figure 8. The Panametrics 500PR pulser (Panametrics, Waltham, MA) was set to pulse at an appropriately low repetition rate so as to avoid overlap of signals.

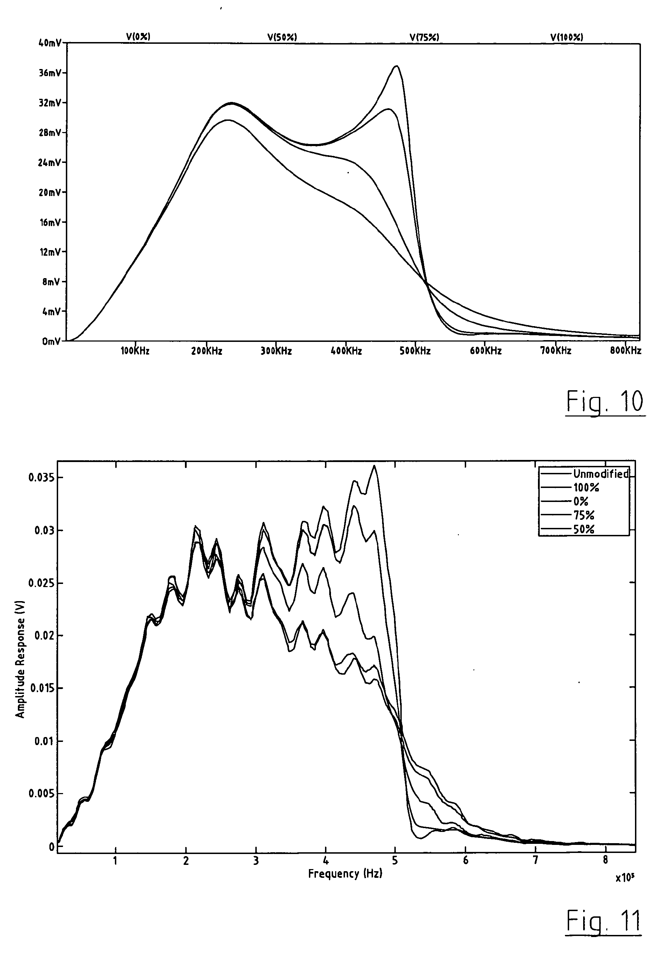

Using the experimental setup as illustrated in Figure 8 and circuit as illustrated in Figure 2, simulation results for bandwidth modification for the chosen example transducers, which are a pair of CUTs with a transmitter capacitance of 651pF and a receiver capacitance of 250pF, film thickness of 5um PET, can be seen in Figure 10.

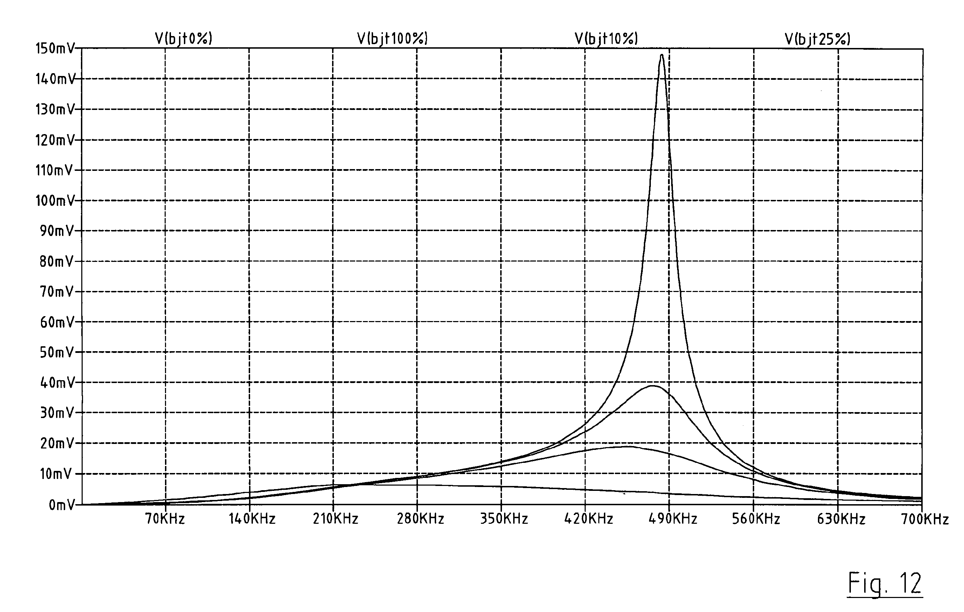

The experimental results obtained for the configuration as simulated in Figure 8 can be seen in Figure 11 where the legend denotes the level of resistance as a percentage of total (10kΩ). These results depict the changing selective resistance (Rx) for an inductance (Lx) of 40uH and a capacitance (Cx) of 2nF. The manipulation of the transmission envelope bandwidth is clearly observable. Simulation results for the manipulation of the envelope of the system using the BJT based differential amplifier design can be seen in Figure 12. The active results presented seek to produce off resonance peaks in order to demonstrate the ability of selective networks and ultimately the designs presented in this patent not only to expand bandwidth through boosting off resonance signals but also to modify the properties of a transducer as seen by the transmit network from a broadband device to a highly selective device at a frequency determined by the selective network.

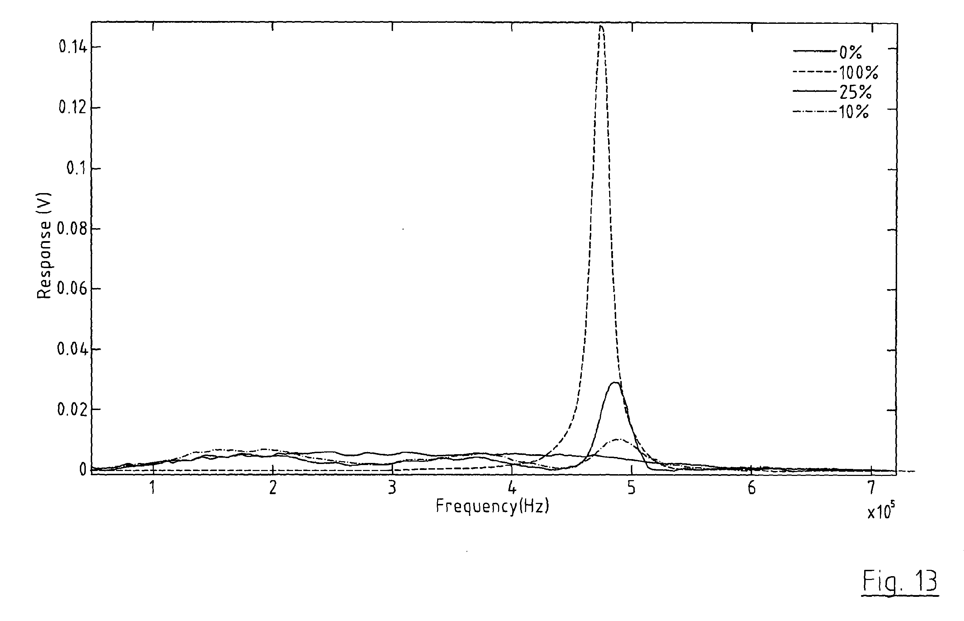

Results obtained for the BJT differential amplifier design obtained using the experimental setup as illustrated in Figure 8 for the values simulated in Figure 12 can be seen in Figure 13. It is evident from these results that the experimental data closely correlates with the simulated data and that selective networks and consequentially equalisers can be used not only for bandwidth expansion of ultrasonic devices but also to create highly resonant ultrasonic transmitters for broadband devices

The present invention provides that the bandwidth, skirt selectivity and resonant behaviour of an ultrasonic transducer can be modified significantly through the use of selective networks placed close to the transducer (in an electrical sense). It will be appreciated that with the appropriate use of a selective network a generic transducer mechanical design can be tailored for a large number of applications within the limits of cicuit design.

It will be appreciated that the present invention provides improved performance for high-power ultrasonic transduction, for example in medical applications.

It will be further appreciated that the terms 'manipulating' and 'conditioning' effectively mean the same thing in an engineering context of controlling and should be afforded the widest possible interpretation.

The invention is not limited to the embodiments hereinbefore described but may be varied in both construction and detail.

## Claims

1. A parametric equalizer, suitable for use in an analogue circuit, **characterised in that** the parametric equalizer comprises:
a switching capacitor filter circuit; and
an oscillator wherein the oscillator controls the operation of the switching capacitor filter circuit.

2. The parametric equalizer of claim 1 wherein the oscillator is a voltage controlled oscillator (VCO), or a current controlled oscillator, or a frequency controlled oscillator.

3. The parametric equalizer of claims 1 or 2 wherein said parametric equalizer is coupled to a transducer that operates on a capacitive or electrostatic principle, such that said parametric equalizer conditions transmission and reception characteristics of said transducer.

4. The parametric equalizer of claim 3 wherein the transducer is a Capacitive Ultrasonic Transducer (CUT).

5. The parametric equalizer of claim 1 wherein said parametric equalizer is coupled to a transducer that operates on a piezoelectric, ferroelectric, electrostrictive, magnetostrictive, piezoresistive, electromagnetic or other operating principle such that said parametric equalizer conditions transmission and reception characteristics of said transducer.

6. The parametric equalizer of claim 5 wherein the transducer is a Capacitive Micro-machined Ultrasonic Transducer (CMUT).

7. The parametric equalizer of any of claims 3 to 6 wherein the equalizer comprises a means of manipulation of a single pole/zero within the transducer response characteristic to modify a response characteristic as desired.

8. The parametric equalizer of claim 7 wherein the manipulation means comprises a first order filter circuit.

9. The parametric equalizer as claimed in any of claims 3 to 6 wherein the equalizer comprises means for manipulating multiple poles/zeros within the transducer response characteristic to modify the response characteristic as desired.

10. The parametric equalizer of claim 9 wherein the manipulation means comprises at least one bi-quadratic filter circuit.

11. The parametric equalizer of claims 3 to 10 wherein the transducer comprises means for using multiple poles/zeros to shift the centre frequency of the response.

12. The parametric equalizer of claim 3 to 10 wherein the transducer comprises means for using multiple poles/zeros to manipulate the transient response of the transducer.

13. A circuit for use to condition the transmission and/or reception signals of a CUT, CMUT, or other transducer circuit, said circuit comprising:
an equivalent inductor circuit, for example a resonator circuit, having at least one operational amplifier; and
a sliding rail element coupled to said operational amplifier.

14. The circuit of claim 13 wherein the sliding rail element conditions the signal to an approximate level.

15. The circuit of claim 14 wherein the operational amplifier fine tracks the conditioned signal.
